(19) **Europäisches Patentamt / European Patent Office / Office européen des brevets**

(11) **EP 3 167 979 A1**

(12) **EUROPEAN PATENT APPLICATION**
published in accordance with Art. 153(4) EPC

(43) Date of publication:
**17.05.2017 Bulletin 2017/20**

(21) Application number: **15818461.4**

(22) Date of filing: **26.03.2015**

(51) Int Cl.:
*B22F 1/00* (2006.01)   *C09C 1/02* (2006.01)
*C09D 5/24* (2006.01)   *C09D 201/00* (2006.01)
*C25C 5/02* (2006.01)   *H01B 1/00* (2006.01)
*H01B 1/22* (2006.01)   *H01B 5/00* (2006.01)

(86) International application number:
**PCT/JP2015/059484**

(87) International publication number:
**WO 2016/006285 (14.01.2016 Gazette 2016/02)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **07.07.2014 JP 2014140055**

(71) Applicant: **Sumitomo Metal Mining Co., Ltd. Tokyo 105-8716 (JP)**

(72) Inventors:
• **OKADA, Hiroshi**
  Niihama-shi
  Ehime 792-0002 (JP)
• **YAMASHITA, Yu**
  Niihama-shi
  Ehime 792-0002 (JP)

(74) Representative: **Jones, Nicholas Andrew**
  **Withers & Rogers LLP**
  **4 More London Riverside**
  **London, SE1 2AU (GB)**

(54) **COPPER POWDER AND ELECTRICALLY CONDUCTIVE PASTE, ELECTRICALLY CONDUCTIVE COATING, ELECTRICALLY CONDUCTIVE SHEET, AND ANTISTATIC COATING USING SAME**

(57)   To provide a copper powder exhibiting a high electric conductivity suitable for a metallic filler used in an electrically conductive paste, a resin for electromagnetic shielding, an antistatic coating, etc., and having excellent uniform dispersibility required for forming a paste so as to inhibit an increase in viscosity due to flocculation. This copper powder 1 forms a branch shape having a plurality of branches through the conglomeration of copper particles 2. The copper particles 2 have a spheroidal shape, with diameters ranging from 0.2 $\mu$m-0.5 $\mu$m, inclusive, and lengths ranging from 0.5 $\mu$m-2.0 $\mu$m, inclusive. The average particle diameter (D50) of the copper powder 1 in which the spheroidal copper particles 2 have conglomerated is 5.0 $\mu$m-20 $\mu$m. By mixing this tree-branch-shaped copper powder 1 into a resin, it is possible to produce an electrically conductive paste, etc., exhibiting excellent electric conductivity, for example.

FIG. 1

**Description**

TECHNICAL FIELD

The present invention relates to a copper powder, more particularly, to a new dendritic copper powder that is composed of a cluster of fine copper particles having a single crystal structure and can improve electric conductivity by being used as a material for an electrically conductive paste and the like.

BACKGROUND ART

A paste such as a resin type paste or a calcined type paste using a metal filler such as a silver powder or a copper powder is frequently used in the formation of a wiring layer, an electrode, and the like in an electronic device.

A metal filler paste of silver or copper is applied or printed on various kinds of substrates of an electronic device and the like and then subjected to a treatment of heat curing or heat calcination to form an electrically conductive film constituting a wiring layer, an electrode, or the like.

For example, a resin type electrically conductive paste is composed of a metal filler, a resin, a curing agent, a solvent, and the like, and it is formed into an electrically conductive film by being printed on an electric conductor circuit pattern or a terminal and cured by heating at from 100°C to 200°C so as to form a wire and an electrode. In a resin type electrically conductive paste, the thermosetting resin is cured and shrunk by heat, and metal fillers are thus joined by pressure and brought into contact with one another so that the metal fillers overlap each other, and as a result, an electrically connected current path is formed. This resin type electrically conductive paste is treated at a curing temperature of 200°C or lower so that it is often used in a substrate using a material susceptible to heat such as a printed wiring board.

A calcination type electrically conductive paste is composed of a metal filler, glass, a solvent, and the like, and it is formed into an electrically conductive film by being printed on an electric conductor circuit pattern or a terminal and calcined by heating at from 600°C to 800°C so as to form a wire and an electrode. The calcination type electrically conductive paste is treated at a high temperature so that electrical continuity is secured as the metal fillers are sintered together. This calcination type electrically conductive paste cannot be used in a printed wiring board using a resin material since it is treated at a high temperature for calcination in this manner, but it has a feature that low resistance is easily obtained since the metal fillers are connected by sintering. Such a calcination type electrically conductive paste is used, for example, in an external electrode of a multilayer ceramic capacitor or the like.

As a metal filler to be used in these resin type electrically conductive paste and calcination type electrically conductive paste, a copper powder that is less expensive than a silver powder tends to be used due to a tendency of cost reduction.

Meanwhile, electromagnetic wave shield is used to prevent the generation of electromagnetic noise from an electronic device, and particularly in recent years, the casing of a personal computer or a mobile phone is made of a resin, and thus a method to thinly form a metal film by a vapor deposition method or a sputtering method, a method to apply an electrically conductive coating material, and a method to shield electromagnetic waves by pasting an electrically conductive sheet onto a required place have been proposed in order to secure the electric conductivity of the casing. Among them, a method to disperse a metal filler in a resin and apply the resin and a method to disperse a metal filler in a resin, to process the resin into a sheet, and to paste the sheet onto a casing are often used as a method exhibiting an excellent degree of freedom as it does not require a special facility for the processing step.

However, in such a case of dispersing a metal filler in a resin and applying the resin or processing the resin into a sheet, the dispersion state of the metal filler in the resin is not uniform, and thus a method is required to eliminate the problem by increasing the filling factor of the metal filler in order to obtain electromagnetic wave shielding efficiency. However, in this case, problems that the flexibility of the resin sheet is impaired and the like are caused as well as the weight of the seat increases by the addition of a large amount of metal filler. Hence, for example, it is described in Patent Document 1 that a thin sheet exhibiting an excellent electromagnetic wave shielding effect and also favorable flexibility can be formed by using a scaly metal filler in order to solve these problems.

In addition, an antistatic coating material is used to prevent static electricity problems at semiconductor assembly factories, pharmaceutical factories, hazardous substances handling facilities, printing factories, plastic molding factories, computer rooms, clean rooms, and the like by applying an electrically conductive coating material on the walls, ceiling, floor, manufacturing instruments, and the like so as to prevent electrification and sudden accidents such as static electricity damage and fire. Hitherto, a material having an electrically conductive layer formed on the surface of titanium dioxide has been used from the viewpoint of hiding property, coloring power, and chemical stability as a filler to be used in this antistatic coating material.

Tin oxide doped with antimony is used as an electrically conductive layer formed on the surface of titanium dioxide, but in recent years, studies on an electrically conductive powder in which antimony is not used have been conducted since the toxicity of antimony is a concern, and, for example, tin oxide doped with phosphorus instead of antimony is proposed in Patent Document 2.

However, even in the case of forming an electrically conductive layer on the surface of titanium dioxide by such a method, the conductive properties are in a limited state since the electrically conductive layer is formed on titanium dioxide of a nonconductor so that a material which is far inferior in electric conductivity to a metal is used. Hence, a difference in antistatic ability is caused on a wide range of walls, ceilings, floors, and the like, and a filler exhibiting more favorable electric conductivity is required.

Meanwhile, an electrolytic copper powder precipitated in a dendritic shape called a dendritic shape is known. The dendritic electrolytic copper powder is formed through a process in which copper grows while branching so that copper grows in a needle shape by branching in the secondary direction from copper that has first grown in a needle shape, then further grows in a needle shape from the secondary direction to the tertiary direction, and the like, furthermore, each branch also has a shape so that tree leaves grow on the branches as the width of each branch spreads and the like. In this manner, a dendritic electrolytic copper powder has a large surface area as one copper powder and exhibits excellent moldability and sinterability, and it is thus used as a raw material for an oil-retaining bearing, a mechanical part, or the like as a powder metallurgy application. In particular, the miniaturization of an oil-retaining bearing and the like has progressed, and the oil-retaining bearing and the like are required to be porous, thinned, and complicatedly shaped along with this. In order to meet these requirements, for example, it has been indicated in Patent Document 3 that the copper powder can be molded to have a high strength since the dendrites of the adjacent electrolytic copper powders are intertwined with one another at the time of the compression molding so as to be firmly connected to one another by further developing the dendritic shape. It is described that it is possible to utilize the fact that a larger number of contact points are formed as compared to a spherical shape since the copper powder has a dendritic shape in the case of being utilized as a metal filler of an electrically conductive paste or an electromagnetic wave shield.

However, in the case of using a dendritic copper powder in an application as an electrically conductive paste, the particle size of an ordinary dendritic copper powder is significantly large. Hence, for example, it is described in Patent Document 4 that a dendritic copper powder to which oil for antioxidation is attached is ground by using a jet mill for miniaturization.

In addition, for example, a method for producing a copper powder for an electrically conductive coating material which can be soldered as a copper powder for an electrically conductive coating material which exhibits favorable solderability and can be soldered is disclosed in Patent Document 5, in which a dendritic copper powder that is obtained by pulverizing a dendritic copper powder having a granular shape and has a rod shape and a maximum particle diameter of 44 μm or less is pulverized by a grounder to obtain a rod-shaped copper powder having an average particle diameter of 10 μm or less, and this copper powder is treated with an acid pickling liquor composed of an inorganic acid or an organic acid to dissolve and remove the oxide film on the surface of the copper powder, washed with water, then sprayed with a quick drying organic solvent, and dried with hot air.

In addition, for example, it is described in Patent Document 6 as well that a dendritic electrolytic copper powder cannot be used as a metal filler of an electrically conductive paste and the like with its own shape, and the dendritic electrolytic copper powder is thus ground and densified in the air atmosphere or an inert atmosphere by using a high-pressure jet air whirl swirl vortex type jet mill to obtain a spherical or granular fine copper powder having an average particle diameter of from 1 to 6 μm.

In addition, for example, it is indicated in Patent Document 7 as well that a copper powder that is obtained by the electrolytic precipitation method and has an average size of from 25 to 50 μm is allowed to collide with one another by using a dry type fluid energy mill or a copper powder obtained by electrolytic precipitation is allowed to collide against a collision plate to grind the copper powder into a fine copper powder.

As described above, in the case of utilizing a copper powder as a metal filler of an electrically conductive paste, a resin for electromagnetic wave shielding, an antistatic coating material, or the like, although a copper powder having a dendritic shape is optimal for securing high electric conductivity, there is a problem that the dendritic copper powders are intertwined with one another causing aggregation and the dendritic copper powders are thus not uniformly dispersed in the resin and the viscosity of the paste increases due to aggregation causing a problem in wiring formation by printing on the other hand.

In addition, as an antistatic application as well, a metal filler has not been suitable from the viewpoint of colorability. In this manner, there have been no copper powders that can achieve both contradictory properties.

Patent Document 1: Japanese Unexamined Patent Application, Publication No. 2003-258490
Patent Document 2: Japanese Patent No. 5095943
Patent Document 3: Japanese Unexamined Patent Application, Publication No. 2011-58027
Patent Document 4: Japanese Unexamined Patent Application, Publication No. 2000-80408
Patent Document 5: Japanese Unexamined Patent Application, Publication No. H6-158103
Patent Document 6: Japanese Unexamined Patent Application, Publication No. 2008-13837
Patent Document 7: Japanese Unexamined Patent Application, Publication No. H9-3510

DISCLOSURE OF THE INVENTION

Problems to be Solved by the Invention

The present invention has been proposed in view of the circumstances as described above, and an object thereof is to provide a copper powder which exerts high electric conductivity suitable as a metal filler to be applied in an electrically conductive paste, a resin for electromagnetic wave shielding, an antistatic coating material, or the like, exhibits excellent uniform dispersibility required to be formed into a paste, and has a suppressed increase in viscosity due to aggregation.

Means for Solving the Problems

The present inventors have found out that a copper powder can be uniformly mixed with, for example, a resin while securing excellent electric conductivity and can be suitably used in an application such as an electrically conductive paste as it is a copper powder that is formed as copper particles having an elliptical shape having a predetermined diameter and a predetermined length gather and has a fine dendritic shape, thereby completing the present invention. In other words, the present invention provides the following.

(1) A first aspect of the present invention is a copper powder including copper particles constituting a dendritic shape having a plurality of branches by gathering, in which the copper particles have an elliptical shape having a size in a range of from 0.2 $\mu$m to 0.5 $\mu$m in diameter and from 0.5 $\mu$m to 2.0 $\mu$m in length and an average particle diameter (D50) of the copper powder formed by gathering of the elliptical copper particles is from 5.0 $\mu$m to 20 $\mu$m.
(2) A second aspect of the present invention is the copper powder according to the first aspect, in which a diameter of the branch part constituting the dendritic shape is from 0.5 $\mu$m to 2.0 $\mu$m.
(3) A third aspect of the present invention is the copper powder according to the first or second aspect, in which a bulk density of the copper powder is from 0.3 g/cm$^3$ to 5.0 g/cm$^3$.
(4) A fourth aspect of the present invention is the copper powder according to any one of the first to third aspects, in which a crystallite diameter in the Miller index of a (111) plane of the copper particles by X-ray diffraction is from 800 Å to 3000 Å.
(5) A fifth aspect of the present invention is a copper powder formed by grinding the copper powder according to any one of the first to fourth aspects until to have an average particle diameter (D50) of 2.0 $\mu$m or less.
(6) A sixth aspect of the present invention is a copper powder including the copper powder according to any one of the first to fifth aspects at a proportion of 20% by mass or more to the entire copper powders.
(7) A seventh aspect of the present invention is the copper powder according to the sixth aspect, including a copper powder having a size of from 0.5 $\mu$m to 10 $\mu$m in average particle diameter (D50).
(8) An eighth aspect of the present invention is an electrically conductive paste formed by dispersing the copper powder according to any one of the first to seventh aspects in a resin.
(9) A ninth aspect of the present invention is an electrically conductive coating material for electromagnetic wave shielding using the copper powder according to any one of the first to seventh aspects.
(10) A tenth aspect of the present invention is an electrically conductive sheet for electromagnetic wave shielding using the copper powder according to any one of the first to seventh aspects.
(11) An eleventh aspect of the present invention is an antistatic coating material using the copper powder according to any one of the first to seventh aspects.

Effects of the Invention

The copper powder according to present invention exhibits high electric conductivity suitable as a metal filler to be used in an electrically conductive paste, a resin for electromagnetic wave shielding, an antistatic coating material, or the like. In addition, it exhibits excellent uniform dispersibility required to be formed into a paste and has suppressed increase in viscosity due to aggregation. Consequently, this copper powder can be suitably used in an electrically conductive paste, an electrically conductive coating material for electromagnetic wave shielding, and an electrically conductive sheet, or an antistatic coating material or the like.

BRIEF DESCRIPTION OF THE DRAWINGS

Fig. 1 is a diagram which schematically illustrates a specific shape of a dendritic copper powder.

Fig. 2 is a photograph which illustrates an observation image when a dendritic copper powder is observed through a scanning electron microscope (SEM) at 10,000-times magnification.

Fig. 3 is a photograph which illustrates an observation image when a dendritic copper powder is observed through a scanning electron microscope (SEM) at 5,000-times magnification.

Fig. 4 is a photograph which illustrates an observation image when the appearance of a dendritic copper powder after being ground is observed through a scanning electron microscope (SEM) at 10,000 times magnification.

Fig. 5 is a photograph which illustrates an observation image when the copper powder obtained in Comparative Example 1 is observed through a scanning electron microscope (SEM).

## PREFERRED MODE FOR CARRYING OUT THE INVENTION

Hereinafter, specific embodiments (hereinafter, referred to as the "present embodiment") of the copper powder according to the present invention will be described in detail with reference to the drawings. Incidentally, the present invention is not limited to the following embodiments, and various modifications are possible without changing the essence of the present invention.

<<1.Dendritic copper powder>>

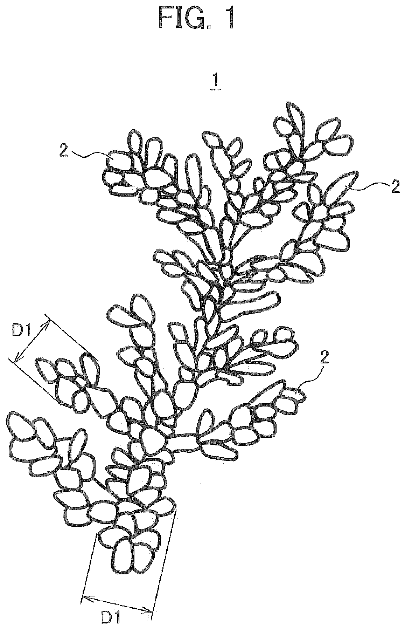

Fig. 1 is a schematic diagram which illustrates a specific shape of the copper powder according to the present embodiment. As illustrated in the schematic diagram of Fig. 1, a copper powder 1 according to the present embodiment is a copper powder having a dendritic shape having a plurality of branches (hereinafter, the copper powder according to the present embodiment is also referred to as the "dendritic copper powder"). This dendritic copper powder 1 is constituted as fine copper particles 2 having an elliptical shape gather, and more specifically, the fine copper particles are elliptical copper particles having a size in a range of from 0.2 $\mu$m to 0.5 $\mu$m in diameter and from 0.5 $\mu$m to 2.0 $\mu$m in length. Moreover, the dendritic copper powder 1 of a cluster of elliptical copper particles has an average particle diameter (D50) of from 5.0 $\mu$m to 20 $\mu$m.

This dendritic copper powder 1 can be obtained by immersing an anode and a cathode in an electrolytic solution which exhibits acidity by sulfuric acid and contains a copper ion and allowing a direct current to flow through the electrolytic solution for electrolysis so as to precipitate the dendritic copper powder on the cathode although the production method will be described in detail later. In other words, it is possible to precipitate and form the dendritic copper powder 1 having a small shape as described above by electrolysis without conducting physical treatment such as grinding or pulverization. For example, in Patent Document 5, a dendritic copper powder having a maximum particle diameter of 44 $\mu$m or less is ground into a rod-shaped copper powder having an average particle diameter of 10 $\mu$m or less by using a grinder to form a copper powder for an electrically conductive coating material. In this manner, a dendritic copper powder of the prior art has a significantly large shape, thus cannot be utilized as it is, and is thus ground into a smaller shape, and then utilized. Incidentally, a rod-shaped copper powder having a ground shape of 10 $\mu$m or less is obtained, and it is thus considered that the shape of the dendritic copper powder of the prior art is a dendritic copper powder formed by gathering of a shape of 10 $\mu$m or less.

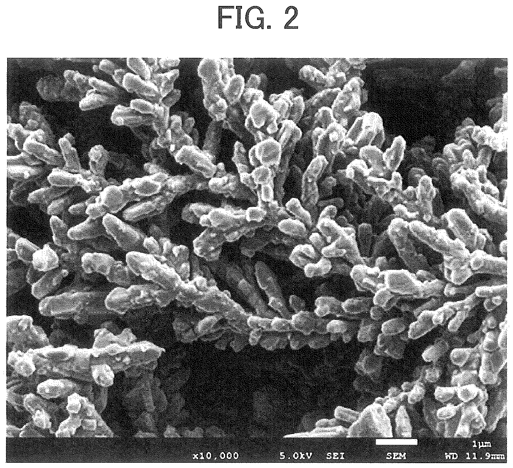

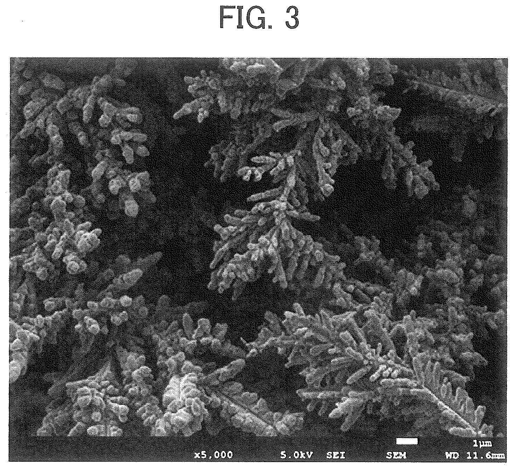

Fig. 2 and Fig. 3 are photographs which illustrate an example of an observation image when the dendritic copper powder 1 according to the present embodiment is observed through a scanning electron microscope (SEM). Incidentally, Fig. 2 illustrates the dendritic copper powder 1 observed at a 10,000-times magnification, and Fig. 3 illustrates the dendritic copper powder 1 observed at a 5,000-times magnification.

As illustrated in the observation images of Fig. 2 and Fig. 3, the copper powder 1 according to the present embodiment is in a dendritic precipitated state. Moreover, this dendritic copper powder 1 forms a dendritic shape having a plurality of branches as the fine copper particles 2 having an elliptical shape gather.

Here, the fine copper particles 2 constituting the dendritic copper powder 1 have an elliptical shape having a diameter of 0.5 $\mu$m or less and a length of 2.0 $\mu$m or less.

More specifically, the diameter of the fine copper particles 2 is 0.5 $\mu$m or less. The thickness (diameter) ("D1" in the schematic diagram of Fig. 1) of the branch part of the dendritic copper powder 1 increases in a case in which the fine copper particles 2 gather to form a dendritic shape when the diameter of the fine copper particles 2 is thicker than 0.5 $\mu$m. The distance between the branches of the dendritic copper powder 1 narrows and the dendritic copper powder 1 has a dense shape as a whole when the thickness of the branch part of the dendritic copper powder 1 increases in this manner, and it is thus impossible to exert the effect of a dendritic shape. In other words, it is impossible to sufficiently exert the effect of increasing the contact area in which the copper powders 1 come in contact with one another.

On the other hand, the dendritic copper powder 1 is in a fine whisker state, for example, as a pine needle when the thickness of the branch part of the dendritic copper powder 1 formed by the fine copper particles 2 is too thin, and it is thus impossible to secure sufficient electric conductivity in a case in which the copper powders 1 come into contact with one another. Hence, the diameter of the fine copper particles 2 is set to from 0.2 $\mu$m to 0.5 $\mu$m due to these facts.

The length of the fine copper particles 2 is 2.0 $\mu$m or less. The number of contact points tends to decrease when the copper powders 1 come into contact with one another when the fine copper particles 2 have an elongated shape having a length of longer than 2.0 $\mu$m. In other words, as the copper powder 1 is a cluster of fine copper particles 2 having a length of 2.0 $\mu$m or less, fine protrusions are formed on the branch part of the dendritic copper powder 1 and it is thus possible to secure a large number of contact points among the dendritic copper powders 1 by this as it can be confirmed from the observation results illustrated in Fig. 2 as well.

However, the distance between the branches of the dendritic copper powder 1 narrows and the dendritic copper powder 1 has a dense shape as a whole when the fine copper particles 2 have an elongated shape having a length of more than 2.0 $\mu$m so that the number of contact points among the dendritic copper powders 1 rather tends to decrease. On the other hand, the formation of protrusions on the branch part does not occur when the length of the fine copper particles 2 is too short. Hence, the length of the fine copper particles 2 is set to from 0.5 $\mu$m to 2.0 $\mu$m due to these facts.

In addition, it is preferable that the thickness (diameter) D1 of the branch part of the dendritic copper powder 1 in which the fine copper particles 2 are gathered is 2.0 $\mu$m or less. The distance between the branches of the dendritic copper powder 1 narrows and the dendritic copper powder 1 has a dense shape as a whole when the thickness D1 of the branch part exceeds 2.0 $\mu$m. Accordingly, the number of contact points decreases and the contact area decreases, and the effect as a copper powder having a dendritic shape is thus not sufficiently exerted. Incidentally, the lower limit value of the thickness D1 of this branch part is not particularly limited, but it is preferably 0.5 $\mu$m or more since the dendritic copper powder 1 is a cluster of the fine copper particles 2 having a diameter of 0.2 $\mu$m or more (0.2 $\mu$m to 0.5 $\mu$m).

The thickness (average particle diameter (D50)) of the dendritic copper powder 1 formed as such fine copper particles 2 gather is from 5.0 $\mu$m to 20 $\mu$m.

Here, for example, as pointed out in Patent Document 3, a problem of a dendritic copper powder is that the dendritic copper powders are intertwined with one another to cause aggregation and are not uniformly dispersed in the resin in some cases when the metal filler in the resin has a developed dendritic shape in the case of utilizing the dendritic copper powder as a metal filler of an electrically conductive paste, a resin for electromagnetic wave shielding, or the like. In addition, the viscosity of the paste increases due to the aggregation so as to cause a problem in wiring formation by printing. This is caused by a large shape of the dendritic copper powder, and the size of the shape of the dendritic copper powder is required to be decreased in order to solve this problem while taking advantage of the dendritic shape. However, it is impossible to secure the dendritic shape when the dendritic copper powder is too small. Hence, an average particle diameter of the dendritic copper powder is required to have a size larger than a predetermined size in order to secure the effect of being a dendritic shape, namely, the effect that the dendritic copper powder has a large surface area, exhibits excellent moldability and sinterability, and can be molded to have a high strength by being strongly connected to one another via a branch-shaped place as it has a three-dimensional shape.

In this regard, the average particle diameter of the dendritic copper powder 1 according to the present embodiment is from 5.0 $\mu$m to 20 $\mu$m. The surface area increases and favorable moldability and sinterability can be secured as the average particle diameter is from 5.0 $\mu$m to 20 $\mu$m. Moreover, the dendritic copper powder 1 has a dendritic shape as well as the elliptical fine copper particles 2 having the predetermined diameter and length described above gather to form a dendritic shape in this manner, and it is thus possible to secure more contact points among the copper powders 1 by the three-dimensional effect of being dendritic and the effect of being dendritically formed by the elliptical fine copper particles 2.

In addition, the bulk density of the dendritic copper powder 1 is not particularly limited, but it is preferably in a range of from 0.3 g/cm$^3$ to 5.0 g/cm$^3$. There is a possibility that contact points among the copper powders 1 cannot be sufficiently secured when the bulk density is less than 0.3 g/cm$^3$. On the other hand, the average particle diameter of the dendritic copper powder 1 also increases, the surface area decreases, and the moldability and sinterability thus deteriorate in some cases when the bulk density exceeds 5.0 g/cm$^3$.

In addition, the dendritic copper powder 1 is not particularly limited, but it is preferable that the crystallite diameter thereof is in a range of from 800 Å (angstrom) to 3000 Å. When the crystallite diameter is less than 800 Å, the fine copper particles 2 constituting the dendritic copper powder 1 tend to have a shape closer to a spherical shape rather than an elliptical shape, and it is difficult to secure a sufficiently large contact area, and there is a possibility that the electric conductivity decreases. On the other hand, when the crystallite diameter exceeds 3,000 Å, the average particle diameter of the dendritic copper powder 1 also increases, the surface area decreases, and the moldability and sinterability thus deteriorate in some cases.

Here, the crystallite diameter is determined from the diffraction pattern obtained by using an X-ray diffraction measuring apparatus on the basis of the Scherrer equation expressed by the following Equation (1), and it is a crystallite diameter in Miller index of the (111) plane by X-ray diffraction.

$$D = 0.9 \, \lambda/\beta \, \cos \theta \, \cdots \, \text{Equation (1)}$$

(Incidentally, D: crystallite diameter (Å), β: diffraction peak spread (rad) depending on crystallite size, λ: wavelength of X-ray [CuKα] (Å), and θ: diffraction angle (°).)

Incidentally, it is possible to obtain the same effect as the copper powder composed only of the dendritic copper powder when the dendritic copper powder having the shape as described above accounts for a predetermined proportion in the obtained copper powder when observed through an electron microscope although copper powders having shapes other than the shape are mixed therein. Specifically, copper powders having shapes other than the shape described above may be contained in the obtained copper powder as long as the dendritic copper powder having the shape described above accounts for 65% by number or more, preferably 80% by number or more, and more preferably 90% by number or more in the entire copper powders when observed through an electron microscope (for example, 500-times to 20,000-times).

<<2.Production method for dendritic copper powder>>

The dendritic copper powder 1 according to the present embodiment can be produced by a predetermined electrolytic method using, for example, a solution which exhibits acidity by sulfuric acid and contains a copper ion as an electrolytic solution.

Upon electrolysis, for example, the solution which exhibits acidity by sulfuric acid and contains a copper ion described above is accommodated in an electrolytic cell in which metallic copper is installed as the anode and a stainless steel plate, a titanium plate, or the like is installed as the cathode and an electrolytic treatment is conducted by applying a direct current to the electrolytic solution at a predetermined current density. This makes it possible to precipitate (electrodeposit) the dendritic copper powder 1 on the cathode along with energization. Particularly, in the present embodiment, it is possible to precipitate the dendritic copper powder 1 in which the elliptical fine copper particles 2 gather to form a dendritic shape on the surface of the cathode by only the electrolysis without subjecting the copper powder which is obtained by electrolysis and has a granular shape or the like to mechanical deformation processing or the like using a medium such as a ball.

More specifically, as the electrolytic solution, for example, one that contains a water-soluble copper salt, sulfuric acid, an additive such as a polyether compound, and a chloride ion can be used.

The water-soluble copper salt is a copper ion source for supplying a copper ion, and examples thereof may include copper sulfate such as copper sulfate pentahydrate, copper chloride, and copper nitrate, but the water-soluble copper salt is not limited thereto. In addition, the concentration of the copper ion in the electrolytic solution can be set to about from 1 g/L to 20 g/L and preferably about from 5 g/L to 10 g/L.

Sulfuric acid is an acid that is used to prepare an electrolytic solution exhibiting acidity from sulfuric acid. The concentration of sulfuric acid in the electrolytic solution may be set to about from 20 g/L to 300 g/L and preferably about from 50 g/L to 150 g/L as the concentration of free sulfuric acid. This concentration of sulfuric acid affects the electric conductivity of the electrolytic solution and it thus affects the uniformity of the copper powder obtained on the cathode.

As an additive, for example, a polyether compound can be used. This polyether compound contributes to the shape control of the copper powder to be precipitated together with the chloride ion to be described later, and it is thus possible to form the copper powder to be precipitated on the cathode into the dendritic copper powder 1 in which elliptical fine copper particles 2 having a predetermined diameter and a predetermined length gather to form a dendritic shape.

The polyether compound is not particularly limited, and examples thereof may include polyethylene glycol (PEG) and polypropylene glycol (PPG). Incidentally, as the polyether compound, one kind may be added singly or two or more kinds may be added concurrently. In addition, the amount of the polyether compound added is preferably set to an amount so that the concentration of the polyether compound in the electrolytic solution is in a range of about from 0.1 mg/L to 500 mg/L.

The chloride ion can be contained in the electrolytic solution by adding a compound (chloride ion source) for supplying a chloride ion such as hydrochloric acid and sodium chloride thereto. The chloride ion contributes to the shape control of the copper powder to be precipitated together with the additive such as the amine compound described above. The concentration of the chloride ion in the electrolytic solution can be set to about from 1 mg/L to 1000 mg/L, preferably about from 25 mg/L to 800 mg/L, and more preferably about from 50 mg/L to 500 mg/L.

In the method for producing the dendritic copper powder according to the present embodiment, for example, the dendritic copper powder is produced by precipitating and generating a copper powder on the cathode through electrolysis using the electrolytic solution having the composition as described above. A known method can be used as the electrolysis method. For example, the current density is preferably set to a range of from 5 A/dm$^2$ to 30 A/dm$^2$ upon electrolysis using an electrolytic solution exhibiting acidity by sulfuric acid, and the electrolytic solution is energized while being stirred. In addition, the liquid temperature (bath temperature) of the electrolytic solution can be set, for example, to about from 20°C to 60°C.

«3.Application such as electrically conductive paste, electrically conductive coating material, and antistatic coating material»

The dendritic copper powder 1 according to the present embodiment is constituted by the fine copper particles 2 which have an elliptical shape having a size in a range of from 0.2 $\mu$m to 0.5 $\mu$m in diameter and from 0.5 $\mu$m to 2.0 $\mu$m in length and gather to form a dendritic shape and has an average particle diameter (D50) of from 5.0 $\mu$m to 20 $\mu$m as described above. Such a dendritic copper powder 1 has a large surface area and exhibits excellent moldability and sinterability as it has a dendritic shape, and the dendritic copper powder 1 can secure a large number of contact points and exerts excellent electric conductivity as it is constituted by the elliptical fine copper particles 2 having a predetermined diameter and a predetermined length.

In addition, according to the dendritic copper powder 1 having such a predetermined structure, it is possible to suppress aggregation of the dendritic copper powder 1 and to uniformly disperse the dendritic copper powder 1 in the resin even in the case of forming the dendritic copper powder 1 into an electrically conductive paste or the like, and it is also possible to suppress occurrence of defective printing and the like due to an increase in viscosity of the paste, or the like. Hence, the dendritic copper powder 1 can be suitably used in applications such as an electrically conductive paste, an electrically conductive coating material for electromagnetic wave shielding resin, an electrically conductive sheet, and an antistatic coating material.

Specifically, in an application such as an electromagnetic wave shielding resin, it is important for the electromagnetic wave shielding resin layer to exhibit the shielding function without impairing the flexibility thereof by uniformly dispersing a small amount of the metal powder in the electromagnetic wave shielding resin layer, for example, as indicated in Patent Document 1. Hence, a method to arrange a scaly metal powder in the planar direction in the resin is proposed in Patent Document 1. However, it is extremely difficult to orient the entire scaly metal powders in the parallel direction in the resin and it is thus required to orient the entire scaly metal powders in the parallel direction by pressure processing or the like.

In contrast to this, the dendritic copper powder 1 of the present embodiment has the predetermined structure as described above, and it is thus possible to easily secure electric conductivity in the parallel direction due to the dendrite shape of the electromagnetic wave shield, and the dendritic copper powder 1 is a significantly fine copper powder and it can thus exert a sufficiently excellent effect in a thin electromagnetic wave shielding resin layer as well.

In addition, in an application such as an antistatic coating material, one obtained by doping the titanium dioxide surface with antimony or phosphorus has been hitherto used. One using a metal powder is superior from the viewpoint of electrically conductive property, but one containing titanium dioxide as the substrate has been used from the viewpoint of colorability. This is because there is a real circumstance that only one containing titanium dioxide as the substrate can be used but a metal cannot be utilized since the metal color inhibits the color of the coating material although a metal powder is required at a certain content in order to secure the electric conductivity by dispersing the metal powder in the resin.

In contrast to this, the dendritic copper powder 1 of the present embodiment has the predetermined structure as described above, and it is thus possible to secure sufficient electric conductivity although the amount of the copper powder to be dispersed in the resin is small and to sufficiently exert the antistatic property without inhibiting the colorability.

Here, an application example of the application of the dendritic copper powder 1 according to the present embodiment will be described by exemplifying an electrically conductive paste (copper paste). The electrically conductive paste can be fabricated by kneading the copper powder with a binder resin, a solvent, and further an additive such as an antioxidant or a coupling agent if necessary.

In the present embodiment, the electrically conductive paste is constituted so that the dendritic copper powder 1 described above is at a proportion to be an amount of 50% by mass or more, preferably 60% by mass or more, and more preferably 70% by mass or more in the total amount of the copper powders to be mixed with the binder resin and the like. According to such an electrically conductive paste, it is possible to uniformly disperse the copper powder in the resin and to prevent the occurrence of defective printing due to an excessive increase in viscosity of the paste as the dendritic copper powder 1 is contained in the copper powders. In addition, it is possible to exhibit excellent electric conductivity as an electrically conductive paste as the copper powder is a dendritic copper powder 1 composed of a cluster of the elliptical fine copper particles 2 having a predetermined diameter and a predetermined length.

Incidentally, as an electrically conductive paste, for example, a spherical copper powder having an average particle diameter (D50) of about from 0.5 $\mu$m to 10 $\mu$m may be additionally mixed and contained in the electrically conductive paste as long as the dendritic copper powder 1 may be contained therein at a proportion to be an amount of 20% by mass or more as described above.

Specifically, the binder resin is not particularly limited, but an epoxy resin, a phenol resin, or the like can be used. In addition, organic solvents such as ethylene glycol, diethylene glycol, triethylene glycol, glycerin, and terpineol can be used as the solvent. In addition, the amount of the organic solvent added is not particularly limited, but the added amount can be adjusted in consideration of the particle size of the dendritic copper powder 1 so as to obtain a viscosity suitable for an electrically conductive film forming method such as screen printing or a dispenser.

Furthermore, it is also possible to add another resin component for adjustment of viscosity. Examples thereof may include a cellulose-based resin typified by ethyl cellulose, and it is added as an organic vehicle prepared by dissolving the resin component in an organic solvent such as terpineol. Incidentally, the amount of the resin component added is required to be suppressed to an extent to which the sinterability is not inhibited, and it is preferably set to 5% by mass or less with respect to the total amount.

In addition, an antioxidant or the like can be added as an additive for improving electric conductivity after calcination. The antioxidant is not particularly limited, but examples thereof may include a hydroxycarboxylic acid. More specifically, a hydroxycarboxylic acid such as citric acid, malic acid, tartaric acid, or lactic acid is preferable, and citric acid or malic acid having a high adsorptive power to copper is even more preferable. The amount of the antioxidant added can be set, for example, to about from 1 to 15% by mass in consideration of the antioxidation effect, the viscosity of the paste, and the like.

«4.Grinding of dendritic copper powder»

Here, the metal filler to be used is required to be as fine as possible, for example, in the case of forming fine wiring by using an electrically conductive paste. Hence, for example, it is indicated in Patent Document 4 and Patent Document 6 that an electrolytic copper powder is ground by a method using a jet mill or the like. In addition, a dendritic copper powder having a maximum particle diameter of about 44 $\mu$m is pulverized into a rod-shaped copper powder having a small shape having an average particle diameter of 10 $\mu$m or less by using a grinder and then utilized in Patent Document 5 as described above.

A dendritic copper powder of the prior art is a dendritic copper powder in which a shape of 10 $\mu$m or more is gathered. However, the dendritic copper powder of the prior art is ground by a method using a jet mill or the like in order to obtain a fine copper powder by further grinding the dendritic copper powder in Patent Document 4 and Patent Document 6 as described above, but there is a limit in grinding since the shape of the dendritic copper powder of the prior art is significantly large (maximum particle diameter of about 44 $\mu$m) as can be seen from the description in Patent Document 5.

In this regard, the dendritic copper powder 1 according to the present embodiment has a dendritic shape formed as the fine copper particles 2 having an elliptical shape having a size in a range of from 0.2 $\mu$m to 0.5 $\mu$m in diameter and from 0.5 $\mu$m to 2.0 $\mu$m in length gather as described above. Furthermore, the average particle diameter (D50) of the dendritic copper powder 1 is from 5.0 $\mu$m to 20 $\mu$m. Hence, it is significantly easy to grind the dendritic copper powder 1 and it is possible to have a shape still having a fine dendritic shape or a granular shape of 2.0 $\mu$m or less as a shape after grinding.

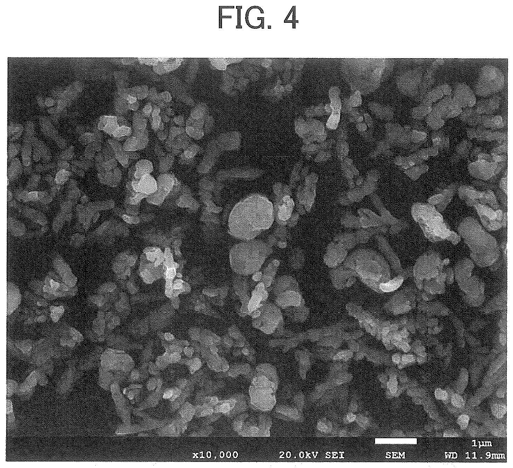

Fig. 4 is a photograph which illustrates an example of the observation image when the appearance of the dendritic copper powder 1 according to the present embodiment after being ground is observed through a scanning electron microscope (10,000 times).

As illustrated in the observation image of Fig. 4, the dendritic copper powder 1 formed as the fine copper particles 2 gather is ground, the shape after grinding is thus a copper powder still having a dendritic shape formed as the fine copper particles 2 gather to some extent, and those in which the fine copper particles 2 are ground as one particle so as to have a shape of 2.0 $\mu$m or less are mixed in the dendritic copper powder 1 after being ground.

In this manner, a feature of the ground product of the dendritic copper powder 1 according to the present embodiment is that a dendritic copper powder and a granular copper powder are contained in the ground product as observed in Fig. 4. From this fact, it can be said that an effect which cannot be definitely exerted, for example, in an electrically conductive paste fabricated by using a copper powder having a simple granular shape can be obtained. In other words, the dendritic copper powder 1 contains a fine dendritic copper powder of 2.0 $\mu$m or less and a granular copper powder of 2.0 $\mu$m or less, and it is thus possible to secure a larger number of contact points among the copper powders than a simple granular shape and to obtain an electrically conductive paste having superior electric conductivity in the case of fabricating an electrically conductive paste by using this dendritic copper powder 1.

EXAMPLES

Hereinafter, the present invention will be described more specifically with reference to Examples together with Comparative Examples, but the present invention is not limited to the following Examples at all.

<Evaluation method>

The copper powders obtained in the following Examples and Comparative Examples were subjected to the observation of shape, the measurement of average particle diameter, the measurement of crystallite diameter, the measurement of specific resistance of the electrically conductive paste, and the evaluation on the electromagnetic wave shielding property by the following methods.

(Observation of shape)

20 arbitrary fields of vison were selected in a field of vision at a magnification of 10,000-times and the appearance of the copper powder contained in the field of vision was observed through a scanning electron microscope (SEM) (model: JSM-7100F manufactured by JEOL Ltd.).

(Measurement of average particle diameter)

The average particle diameter (D50) of the obtained copper powder was measured by using a laser diffraction/scattering method particle size distribution measuring instrument (HRA9320 X-100 manufactured by NIKKISO CO., LTD.).

(Measurement of crystallite diameter)

The crystallite diameter was calculated from the diffraction pattern obtained with an X-ray diffraction measuring apparatus (X'Pert PRO manufactured by PANanalytical B. V.) by a method generally known as the Scherrer equation. (Measurement of specific resistance of electrically conductive paste)

The specific resistance value of the coating film was determined by measuring the sheet resistance value with a four-terminal method using a low resistivity meter (Loresta-GP MCP-T600 manufactured by Mitsubishi Chemical Corporation) and the film thickness of the coating film using a surface roughness and shape measuring instrument (SURFCO M130A manufactured by TOKYO SEIMITSU CO., LTD.) and dividing the sheet resistance value by the film thickness.

(Electromagnetic wave shielding property)

The evaluation of the electromagnetic wave shielding property was carried out by measuring the attenuation factor of the samples obtained in the respective Examples and Comparative Examples by using an electromagnetic wave having a frequency of 1 GHz. Specifically, the level in the case of Comparative Example 1 in which the dendritic copper powder was not used was evaluated as "Δ", a case in which the attenuation factor was worse than the level of Comparative Example 1 was evaluated as "×", a case in which the attenuation factor was more favorable than the level of Comparative Example 1 was evaluated as "O", and a case in which the attenuation factor was superior to the level of Comparative Example 1 was evaluated as "⊙".

In addition, it was confirmed whether the electromagnetic wave shielding property changed or not by bending the fabricated electromagnetic wave shield in order to evaluate the flexibility of the electromagnetic wave shield.

<Production of electrolytic copper powder>

[Example 1]

A titanium electrode plate having an electrode area of 200 mm × 200 mm and a copper electrode plate having an electrode area of 200 mm × 200 mm were installed in an electrolytic cell having a capacity of 100 L as the cathode and the anode, respectively, an electrolytic solution was put in the electrolytic cell, and a direct current was applied to this, thereby precipitating a copper powder on the cathode plate.

At this time, a solution having a composition in which the concentration of copper ion was 10 g/L and the concentration of sulfuric acid was 100 g/L was used as the electrolytic solution. In addition, polyethylene glycol (PEG) having a molecular weight of 400 (manufactured by Wako Pure Chemical Industries, Ltd.) was added as an additive to this electrolytic solution so as to have a concentration of 500 mg/L in the electrolytic solution, and a hydrochloric acid solution (manufactured by Wako Pure Chemical Industries, Ltd.) was further added thereto so that the concentration of chlorine ion (chloride ion) in the electrolytic solution was 50 mg/L.

Thereafter, the temperature of the electrolytic solution adjusted to the concentration described above was maintained at 30°C while circulating the electrolytic solution with a metering pump at a flow rate of 10 L/min, and an electric current was applied thereto so that the current density of the cathode was 20 A/dm$^2$, thereby precipitating a copper powder on the cathode plate.

The electrolytic copper powder precipitated on the cathode plate was mechanically scraped off to the cell bottom of the electrolytic cell by using a scraper and recovered, and the copper powder thus recovered was washed with pure water, then placed in a vacuum dryer, and dried.

The shape of the electrolytic copper powder thus obtained was observed by the method using a scanning electron microscope (SEM) described above, and as a result, the copper powder thus precipitated was a copper powder having a dendritic shape constituted as elliptical copper particles having a size of from 0.2 $\mu$m to 0.5 $\mu$m in diameter and 0.41 $\mu$m in average thereof and from 0.5 $\mu$m to 2.0 $\mu$m in length and 1.6 $\mu$m in average thereof gathered. In addition, the crystallite diameter of the elliptical copper particles was 1450 Å.

In addition, the average particle diameter of the dendritic copper powder formed as the elliptical copper particles gathered was 12.6 $\mu$m. In addition, it was confirmed that a dendritic copper powder having a size of from 0.5 $\mu$m to 2.0 $\mu$m in thickness (diameter) of the branch part and 1.2 $\mu$m in average was formed at a proportion of at least 90% by number or more in the entire copper powders. In addition, the bulk density of the copper powder thus obtained was 0.64 g/cm$^3$.

[Example 2]

A copper powder was precipitated on the cathode plate under the same conditions as in Example 1 except that polyethylene glycol (PEG) having a molecular weight of 400 was added as an additive to the electrolytic solution so as to have a concentration of 1000 mg/L and a hydrochloric acid solution was further added thereto so that the concentration of chlorine ion was 50 mg/L.

The shape of the electrolytic copper powder thus obtained was observed by the method using a scanning electron microscope (SEM) described above, and as a result, the copper powder thus precipitated was a copper powder having a dendritic shape constituted as elliptical copper particles having a size of from 0.2 $\mu$m to 0.5 $\mu$m in diameter and 0.32 $\mu$m in average thereof and from 0.5 $\mu$m to 2.0 $\mu$m in length and 1.4 $\mu$m in average thereof gathered. In addition, the crystallite diameter of the elliptical copper particles was 1956 Å.

In addition, the average particle diameter of the dendritic copper powder formed as the elliptical copper particles gathered was 8.7 $\mu$m. In addition, it was confirmed that a dendritic copper powder having a size of from 0.5 $\mu$m to 2.0 $\mu$m in thickness (diameter) of the branch part and 0.72 $\mu$m in average was formed at a proportion of at least 95% by number or more in the entire copper powders. In addition, the bulk density of the copper powder thus obtained was 0.31 g/cm$^3$.

[Example 3]

A copper powder was precipitated on the cathode plate under the same conditions as in Example 1 except that the electric current was applied so that the current density of the cathode was 10 A/dm$^2$.

The shape of the electrolytic copper powder thus obtained was observed by the method using a scanning electron microscope (SEM) described above, and as a result, the copper powder thus precipitated was a copper powder having a dendritic shape constituted as elliptical copper particles having a size of from 0.2 $\mu$m to 0.5 $\mu$m in diameter and 0.48 $\mu$m in average thereof and from 0.5 $\mu$m to 2.0 $\mu$m in length and 1.8 $\mu$m in average thereof gathered. In addition, the crystallite diameter of the elliptical copper particles was 1105 Å.

In addition, the average particle diameter of the dendritic copper powder formed as the elliptical copper particles gathered was 18.2 $\mu$m. In addition, it was confirmed that a dendritic copper powder having a size of from 0.5 $\mu$m to 2.0 $\mu$m in thickness (diameter) of the branch part and 1.8 $\mu$m in average was formed at a proportion of at least 85% by number or more in the entire copper powders. In addition, the bulk density of the copper powder thus obtained was 0.76 g/cm$^3$.

[Example 4]

Polypropylene glycol (PPG) (manufactured by Wako Pure Chemical Industries, Ltd.) was added as an additive to the electrolytic solution instead of PEG. PPG having a molecular weight of 400 was added so as to have a concentration of 500 mg/L in the electrolytic solution, and a hydrochloric acid solution was added thereto at the same time so that the concentration of chlorine ion was 50 mg/L. A copper powder was precipitated on the cathode plate under the same conditions as in Example 1 except these.

The shape of the electrolytic copper powder thus obtained was observed by the method using a scanning electron microscope (SEM) described above, and as a result, the copper powder thus precipitated was a copper powder having a dendritic shape constituted as elliptical copper particles having a size of from 0.2 $\mu$m to 0.5 $\mu$m in diameter and 0.39 $\mu$m in average thereof and from 0.5 $\mu$m to 2.0 $\mu$m in length and 1.2 $\mu$m in average thereof gathered. In addition, the crystallite diameter of the elliptical copper particles was 1365 Å.

In addition, the average particle diameter of the dendritic copper powder formed as the elliptical copper particles gathered was 9.8 $\mu$m. In addition, it was confirmed that a dendritic copper powder having a size of from 0.5 $\mu$m to 2.0 $\mu$m in thickness (diameter) of the branch part and 0.95 $\mu$m in average was formed at a proportion of at least 90% by number or more in the entire copper powders. In addition, the bulk density of the copper powder thus obtained was 0.44 g/cm$^3$.

[Example 5]

The copper powder fabricated and dried in Example 1 was ground at a grinding pressure of 1 MPa in an oxygen-containing atmosphere by using a jet mill (Nano Grinding Mill NJ-50 manufactured by TOKUJU CORPORATION).
The copper powder thus ground was observed by the method using a scanning electron microscope (SEM) described above, and as a result, it was confirmed that the copper powder became a copper powder which contained a dendritic copper powder formed as fine copper particles having a diameter of from 0.2 $\mu$m to 0.5 $\mu$m and 0.43 $\mu$m in average gathered or a copper powder in which the fine copper particles are one particle and had an average particle diameter (ground particle diameter) of 1.8 $\mu$m or less and the dendritic copper powder was contained at a proportion of 70% by number or more in the entire copper powders. Incidentally, the crystallite diameter of the copper particles was 1002 Å, and the bulk density of the copper powder thus obtained was 1.89 g/cm$^3$.

[Example 6]

The copper powder fabricated and dried in Example 4 was ground at a grinding pressure of 1 MPa in an oxygen-containing atmosphere by using a jet mill (Nano Grinding Mill NJ-50 manufactured by TOKUJU CORPORATION).
The copper powder thus ground was observed by the method using a scanning electron microscope (SEM) described above, and as a result, it was confirmed that the copper powder became a copper powder which contained a dendritic copper powder formed as fine copper particles having a diameter of from 0.2 $\mu$m to 0.5 $\mu$m and 0.37 $\mu$m in average gathered or a copper powder in which the fine copper particles are one particle and had an average particle diameter (ground particle diameter) of 0.98 $\mu$m or less and the dendritic copper powder was contained at a proportion of 80% by number or more in the entire copper powders. Incidentally, the crystallite diameter of the copper particles was 1019 Å, and the bulk density of the copper powder thus obtained was 1.92 g/cm$^3$.

[Comparative Example 1]

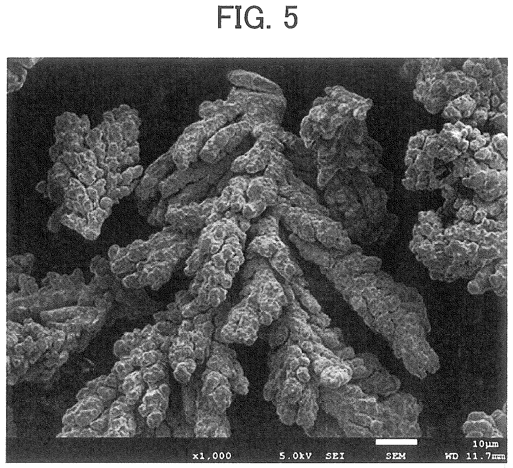

A copper powder was precipitated on the cathode plate in the same manner as in Example 1 except a condition in which PEG as an additive and a chlorine ion were not added to the electrolytic solution.
The shape of the electrolytic copper powder thus obtained was observed by the method using a scanning electron microscope (SEM) described above, and as a result, it was confirmed that the copper powder thus generated was a significantly large dendritic copper powder having a thickness (diameter) of the branch part of more than 10 $\mu$m. In addition, the average particle diameter of the copper powder was 32.4 $\mu$m. Fig. 5 is an image of the copper powder obtained in this Comparative Example 1 observed through an SEM. Incidentally, the crystallite diameter of the copper particles was 824 Å, and the bulk density of the copper powder thus obtained was 2.36 g/cm$^3$.

[Comparative Example 2]

A copper powder was precipitated on the cathode plate in the same manner as in Example 1 except that thiourea (manufactured by Wako Pure Chemical Industries, Ltd.) as an additive was added to the electrolytic solution instead of PEG so as to have a concentration of 500 mg/L and a hydrochloric acid solution was further added thereto so that the concentration of chlorine ion was 50 mg/L.
The shape of the electrolytic copper powder thus obtained was observed by the method using a scanning electron microscope (SEM) described above, and as a result, it was confirmed that the copper powder thus generated was a significantly large dendritic copper powder having a thickness (diameter) of the branch part of more than 10 $\mu$m. In addition, the average particle diameter of the copper powder was 21.2 $\mu$m. Incidentally, the crystallite diameter of the copper particles was 651 Å, and the bulk density of the copper powder thus obtained was 2.28 g/cm$^3$.

[Comparative Example 3]

The copper powder fabricated and dried in Comparative Example 1 was ground at a grinding pressure of 1 MPa in an oxygen-containing atmosphere by using a jet mill (Nano Grinding Mill NJ-50 manufactured by TOKUJU CORPORATION).
The copper powder thus ground was observed by the method using a scanning electron microscope (SEM) described above, and as a result, the average particle diameter (ground particle diameter) of the copper powder obtained by grinding had a size of 8.2 $\mu$m so as not to be one having a small dendritic shape of 2 $\mu$m or less as those obtained in Examples 5 and 6. Incidentally, the crystallite diameter of the copper particles was 763 Å, and the bulk density of the copper powder thus obtained was 2.13 g/cm$^3$.

[Comparative Example 4]

The copper powder fabricated and dried in Comparative Example 2 was ground at a grinding pressure of 1 MPa in an oxygen-containing atmosphere by using a jet mill (Nano Grinding Mill NJ-50 manufactured by TOKUJU CORPORATION).

The copper powder thus ground was observed by the method using a scanning electron microscope (SEM) described above, and as a result, the average particle diameter (ground particle diameter) of the copper powder obtained by grinding had a size of 7.6 $\mu$m so as not to be one having a small dendritic shape of 2 $\mu$m or less as those obtained in Examples 5 and 6. Incidentally, the crystallite diameter of the copper particles was 562 Å, and the bulk density of the copper powder thus obtained was 2.19 g/cm$^3$.

The evaluation results for the copper powders obtained in Examples 1 to 4 and Comparative Examples 1 and 2 described above are summarized in the following Table 1.

[Table 1]

| | Fine copper particles | | | Dendritic copper powder | | |
|---|---|---|---|---|---|---|
| | Diameter($\mu$m) | Length ($\mu$m) | Crystallite diameter (Å) | Average particle diameter($\mu$m) | Thickness of branch part($\mu$m) | Bulk density(cc/g) |
| Example1 | 0.41 | 1.6 | 1450 | 12.6 | 1.2 | 0.64 |
| Example2 | 0.32 | 1.4 | 1956 | 8.7 | 0.72 | 0.31 |
| Example3 | 0.48 | 1.8 | 1105 | 18.2 | 1.8 | 0.76 |
| Example4 | 0.39 | 1.2 | 1365 | 9.8 | 0.95 | 0.44 |
| Comparative Example1 | - | - | 824 | 32.4 | Thicker than 10 | 2.36 |
| Comparative Example2 | - | - | 651 | 21.2 | Thicker than 10 | 2.28 |

<Production of electrically conductive paste>

[Example 7]

With 60 g of the dendritic copper powder obtained in Example 1, 15 g of a phenol resin (PL-2211 manufactured by Gunei Chemical Industry Co., Ltd.) and 10 g of butyl cellosolve (KANTO CHEMICAL CO., INC. Cica Special Grade) were respectively mixed, and the mixture was repeatedly kneaded by using a small kneader (Non-bubbling Kneader NBK-1 manufactured by NIHONSEIKI KAISHA LTD.) for 3 minutes at 1200 rpm three times to be formed into a paste. Upon pasting, the copper powder was uniformly dispersed in the resin without the particles aggregating with one another. The electrically conductive paste thus obtained was printed on glass by using a metal squeegee and cured for 30 minutes at temperatures of 150°C and 200°C in the air atmosphere.

The specific resistance value of the coating film obtained by curing was measured, as a result it was $9.7 \times 10^{-5}$ $\Omega \cdot$cm (curing temperature: 150°C) and $3.8 \times 10^{-5}$ $\Omega \cdot$cm (curing temperature: 200°C), respectively, and it has been found that excellent electric conductivity is exhibited.

[Example 8]

In Example 8, the effect of mixing a spherical copper powder with the dendritic copper powder obtained in Example 1 to form a paste was investigated.

The spherical copper powder was fabricated as follows. In other words, the spherical copper powder was fabricated by grinding and pulverizing an electrolytic copper powder having an average particle diameter of 30.5 $\mu$m (trade name: electrolytic copper powder Cu-300 manufactured by NEXcell Japan) at an air flow rate of 200 L/min, a grinding pressure of 10 kg/cm$^2$, and about 400 g/hour by using a high-pressure jet air whirl swirl vortex type jet mill (NJ type Nano Grinding Mill NJ-30 manufactured by TOKUJU CORPORATION) using eight passes. The spherical copper powder thus obtained had a granular shape and the average particle diameter thereof was 5.6 $\mu$m.

With 40 g of the dendritic copper powder obtained in Example 1 and 10 g of the spherical copper powder fabricated as described above, 15 g of a phenol resin (PL-2211 manufactured by Gunei Chemical Industry Co., Ltd.) and 10 g of butyl cellosolve (KANTO CHEMICAL CO., INC. Cica Special Grade) were respectively mixed, and the mixture was repeatedly kneaded by using a small kneader (Non-bubbling Kneader NBK-1 manufactured by NIHONSEIKI KAISHA LTD.) for 3 minutes at 1200 rpm three times to be formed into a paste. Upon pasting, the copper powder was uniformly dispersed in the resin without aggregating with one another. The electrically conductive paste thus obtained was printed on glass by using a metal squeegee and cured for 30 minutes at temperatures of 150°C and 200°C in the air atmosphere.
The specific resistance value of the coating film obtained by curing was measured, as a result, it was $8.6 \times 10^{-5}$ $\Omega$·cm (curing temperature: 150°C) and $2.1 \times 10^{-5}$ $\Omega$·cm (curing temperature: 200°C), respectively, and it has been found that excellent electric conductivity is exhibited.

[Comparative Example 5]

The properties of an electrically conductive paste from a spherical copper powder were investigated.
Specifically, 15 g of a phenol resin (PL-2211 manufactured by Gunei Chemical Industry Co., Ltd.) and 10 g of butyl cellosolve (KANTO CHEMICAL CO., INC. Cica Special Grade) were respectively mixed with 60 g of the spherical copper powder used in Example 8, and the mixture was repeatedly kneaded by using a small kneader (Non-bubbling Kneader NBK-1 manufactured by NIHONSEIKI KAISHA LTD.) for 3 minutes at 1200 rpm three times to be formed into a paste. Incidentally, upon pasting, an increase in viscosity occurred every time when kneading was repeated. This is considered to be caused by the aggregation of a portion of the copper powder, and it was difficult to uniformly disperse the copper powder. The electrically conductive paste thus obtained was printed on glass by using a metal squeegee and cured for 30 minutes at temperatures of 150°C and 200°C in the air atmosphere.
The specific resistance value of the coating film obtained by curing was measured, as a result, it was $570 \times 10^{-5}$ $\Omega$·cm (curing temperature: 150°C) and $270 \times 10^{-5}$ $\Omega$·cm (curing temperature: 200°C), respectively, and the electrically conductive paste thus obtained had an extremely high specific resistance value and exhibited poorer electric conductivity as compared to the electrically conductive pastes obtained in Examples (Examples 7 and 8).

<Production of electromagnetic wave shield>

[Example 9]

The dendritic copper powder obtained in Example 1 was dispersed in a resin to produce an electromagnetic wave shielding material. Specifically, 50 g of the dendritic copper powder thus obtained was mixed with 100 g of a vinyl chloride resin and 200 g of methyl ethyl ketone, respectively, and the mixture was repeatedly kneaded by using a small kneader for 3 minutes at 1200 rpm three times to be formed into a paste. Upon pasting, the copper powder was uniformly dispersed in the resin without aggregating with one another. Thereafter, this was applied on a substrate formed of a transparent polyethylene terephthalate sheet having a thickness of 100 $\mu$m by using a Mayer bar and dried to form an electromagnetic wave shielding layer having a thickness of 30 $\mu$m.
The evaluation on the property of the electromagnetic wave shield was carried out by measuring the attenuation factor by using an electromagnetic wave having a frequency of 1 GHz. The evaluation results are summarized in the following
Table 2.

[Example 10]

In Example 10, the effect when a spherical copper powder was mixed with the dendritic copper powder obtained in Example 1 and the mixture was dispersed in a resin to produce an electromagnetic wave shielding material was investigated.
The spherical copper powder was fabricated as follows. In other words, the spherical copper powder was fabricated by grinding and pulverizing an electrolytic copper powder having an average particle diameter of 30.5 $\mu$m (trade name: electrolytic copper powder Cu-300 manufactured by NEXcell Japan) at an air flow rate of 200 L/min, a grinding pressure of 10 kg/cm$^2$, and about 400 g/hour by using a high-pressure jet air whirl swirl vortex type jet mill (NJ type Nano Grinding Mill NJ-30 manufactured by TOKUJU CORPORATION) using eight passes. The spherical copper powder thus obtained had a granular shape and the average particle diameter thereof was 5.6 $\mu$m.
With 30 g of the dendritic copper powder obtained in Example 1 and 10 g of the spherical copper powder fabricated as described above, 100 g of a vinyl chloride resin and 200 g of methyl ethyl ketone were respectively mixed, and the mixture was repeatedly kneaded by using a small kneader for 3 minutes at 1200 rpm three times to be formed into a paste. Upon pasting, the copper powder was uniformly dispersed in the resin without aggregating with one another.

Thereafter, this was applied on a substrate formed of a transparent polyethylene terephthalate sheet having a thickness of 100 $\mu$m by using a Mayer bar and dried to form an electromagnetic wave shielding layer having a thickness of 30 $\mu$m.

The electromagnetic wave shielding property was evaluated by measuring the attenuation factor by using an electromagnetic wave having a frequency of 1 GHz. The evaluation results are summarized in the following Table 2.

[Comparative Example 6]

The properties of an electromagnetic wave shield from a spherical copper powder were investigated.

Specifically, 50 g of the spherical copper powder used in Example 8 was mixed with 100 g of a vinyl chloride resin and 200 g of methyl ethyl ketone, respectively, and the mixture was repeatedly kneaded by using a small kneader for 3 minutes at 1200 rpm three times to be formed into a paste. Incidentally, upon pasting, an increase in viscosity occurred every time when kneading was repeated. This is considered to be caused by aggregation of a portion of the copper powder, and it was difficult to uniformly disperse the copper powder. This was applied on a substrate formed of a transparent polyethylene terephthalate sheet having a thickness of 100 $\mu$m by using a Mayer bar and dried to form an electromagnetic wave shielding layer having a thickness of 30 $\mu$m.

The electromagnetic wave shielding property was evaluated by measuring the attenuation factor by using an electromagnetic wave having a frequency of 1 GHz. The evaluation results are summarized in the following Table 2.

The evaluation results on the properties of the electrically conductive pastes and electromagnetic wave shields obtained in Examples 7 to 10 and Comparative Examples 5 and 6 described above are summarized in the following Table 2.

[Table 2]

| | Input amount of copper powder(g) | | Property of electrically conductive paste ($\times 10^{-5}\Omega$cm) | | Property of electromagnetic wave shield | |
|---|---|---|---|---|---|---|
| | Dendritic | Granular | 150°C | 200°C | Plane | Bending |
| Example7 | 60 | 0 | 9.7 | 3.8 | - | - |
| Example8 | 40 | 10 | 8.6 | 2.1 | - | - |
| Example9 | 50 | 0 | - | - | ◎ | ○ |
| Example10 | 30 | 10 | - | - | ◎ | ○ |
| Comparative Example5 | 0 | 60 | 570 | 270 | - | - |
| Comparative Example6 | 0 | 50 | - | - | Δ | × |

<Production of antistatic layer>

[Example 11]

The dendritic copper powder obtained in Example 1 was dispersed in a resin to produce an antistatic layer. Specifically, 200 g of an acrylic resin (A-198-XB manufactured by DIC Corporation) and 200 g of a solvent (mixed solvent prepared by mixing toluene and n-butanol at 1 : 1) were respectively mixed with 5 g of the dendritic copper powder thus obtained, and the mixture was stirred for 30 minutes by using a paint shaker (manufactured by TOYO SEIKI SEISAKU-SHO, LTD.). Thereafter, this was applied on a transparent polyethylene terephthalate sheet by using a Meyer bar so as to have a dry film thickness of 30 $\mu$m.

The specific resistance of the coating film obtained by air drying in the room for 24 hours was measured, and the result was 3.9 $\Omega\cdot$cm.

[Comparative Example 7]

An antistatic layer was formed by using a material that was obtained by doping titanium dioxide with antimony and had been used as an antistatic coating material in the prior art and evaluated.

Specifically, 200 g of an acrylic resin (A-198-XB manufactured by DIC Corporation) and 200 g of a solvent (mixed solvent prepared by mixing toluene and n-butanol at 1 : 1) were respectively mixed with 100 g of needle-shaped electrically conductive titanium oxide (FT 3000 manufactured by ISHIHARA SANGYO KAISHA, LTD.) of a filler obtained by doping titanium dioxide with antimony, and the mixture was stirred for 30 minutes by using a paint shaker (manufactured by TOYO SEIKI SEISAKU-SHO, LTD.). Thereafter, this was applied on a transparent polyethylene terephthalate sheet by using a Meyer bar so as to have a dry film thickness of 30 $\mu$m.

The specific resistance of the coating film obtained by air drying in the room for 24 hours was measured, and the result was 6.8 x $10^5$ $\Omega$·cm, and the antistatic layer thus obtained had a far higher specific resistance value and exhibited poorer electric conductivity as compared to the antistatic layer obtained in Example (Example 11).

From this result, it can be seen that it is possible to exert extremely high electric conductivity by forming an antistatic layer by using the dendritic copper powder obtained in Example 11, moreover to obtain an excellent effect with a small amount of the dendritic copper powder, and to exert the antistatic function without being affected by the metal color.

EXPLANATION OF REFERENCE NUMERALS

1    copper powder (dendritic copper powder)
2    copper particle (fine copper particle)

**Claims**

1. A copper powder comprising copper particles constituting a dendritic shape having a plurality of branches by gathering, wherein
the copper particles have an elliptical shape having a size in a range of from 0.2 $\mu$m to 0.5 $\mu$m in diameter and from 0.5 $\mu$m to 2.0 $\mu$m in length, and
an average particle diameter (D50) of the copper powder formed by gathering of the elliptical copper particles is from 5.0 $\mu$m to 20 $\mu$m.

2. The copper powder according to claim 1, wherein a diameter of the branch part constituting the dendritic shape is from 0.5 $\mu$m to 2.0 $\mu$m.

3. The copper powder according to claim 1 or 2, wherein a bulk density of the copper powder is from 0.3 g/cm$^3$ to 5.0 g/cm$^3$.

4. The copper powder according to any one of claims 1 to 3, wherein a crystallite diameter in the Miller index of a (111) plane of the copper particles by X-ray diffraction is from 800 Å to 3000 Å.

5. A copper powder formed by grinding the copper powder according to any one of claims 1 to 4 until to have an average particle diameter (D50) of 2.0 $\mu$m or less.

6. A copper powder comprising the copper powder according to any one of claims 1 to 5 at a proportion of 20% by mass or more to the entire copper powder.

7. The copper powder according to claim 6, comprising a copper powder having a size of from 0.5 $\mu$m to 10 $\mu$m in average particle diameter (D50).

8. An electrically conductive paste formed by dispersing the copper powder according to any one of claims 1 to 7 in a resin.

9. An electrically conductive coating material for electromagnetic wave shielding using the copper powder according to any one of claims 1 to 7.

10. An electrically conductive sheet for electromagnetic wave shielding using the copper powder according to any one of claims 1 to 7.

11. An antistatic coating material using the copper powder according to any one of claims 1 to 7.

FIG. 1

# FIG. 2

FIG. 3

FIG. 4

FIG. 5

## INTERNATIONAL SEARCH REPORT

| International application No. |
| --- |
| PCT/JP2015/059484 |

**A. CLASSIFICATION OF SUBJECT MATTER**

*B22F1/00*(2006.01)i, *C09C1/02*(2006.01)i, *C09D5/24*(2006.01)i, *C09D201/00*(2006.01)i, *C25C5/02*(2006.01)i, *H01B1/00*(2006.01)i, *H01B1/22*(2006.01)i, *H01B5/00*(2006.01)i

According to International Patent Classification (IPC) or to both national classification and IPC

**B. FIELDS SEARCHED**

Minimum documentation searched (classification system followed by classification symbols)
B22F1/00, C09C1/02, C09D5/24, C09D201/00, C25C5/02, H01B1/00, H01B1/22, H01B5/00

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)
JSTPlus(JDreamIII)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2014-019877 A (The Furukawa Electric Co., Ltd.), 03 February 2014 (03.02.2014), paragraph [0021] (Family: none) | 1-11 |
| A | JP 2011-214032 A (JX Nippon Mining & Metals Corp.), 27 October 2011 (27.10.2011), paragraph [0014]; fig. 1 (Family: none) | 1-11 |
| A | JP 2013-053347 A (Mitsui Mining & Smelting Co., Ltd.), 21 March 2013 (21.03.2013), entire text (Family: none) | 1-11 |

[X] Further documents are listed in the continuation of Box C.    [ ] See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| 16 June 2015 (16.06.15) | 23 June 2015 (23.06.15) |

| Name and mailing address of the ISA/<br>Japan Patent Office<br>3-4-3,Kasumigaseki,Chiyoda-ku,<br>Tokyo 100-8915,Japan | Authorized officer<br><br>Telephone No. |
| --- | --- |

Form PCT/ISA/210 (second sheet) (July 2009)

## INTERNATIONAL SEARCH REPORT

International application No.

PCT/JP2015/059484

C (Continuation). DOCUMENTS CONSIDERED TO BE RELEVANT

| Category* | Citation of document, with indication, where appropriate, of the relevant passages | Relevant to claim No. |
|---|---|---|
| A | JP 2013-100592 A (Mitsui Mining & Smelting Co., Ltd.), 23 May 2013 (23.05.2013), entire text & CN 103056356 A & KR 10-2013-0044132 A & TW 201317311 A | 1-11 |
| A | JP 5503813 B1 (Mitsui Mining & Smelting Co., Ltd.), 28 May 2014 (28.05.2014), entire text & WO 2014/021037 A1 | 1-11 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003258490 A
- JP 5095943 B
- JP 2011058027 A
- JP 2000080408 A
- JP H6158103 B
- JP 2008013837 A
- JP H93510 A